# FASCICULE DE BREVET EUROPEEN

(11) **EP 1 550 158 B1**
(45) Date de publication et mention de la délivrance du brevet: **28.12.2011**
(21) Numéro de dépôt: 03780289.9
(22) Date de dépôt: 03.10.2003
(51) Int. Cl.: H01L 21/762

(54) **REALISATION D UN SUBSTRAT SEMICONDUCTEUR DEMONTABLE ET OBTEN TION D UN ELEMENT SEMICONDUCTEUR.**
HERSTELLUNG VON EINEM ABNEHMBAREN HALBLEITERSUBSTRAT UND EINEM HALBLEITERELEMENT
METHOD FOR MAKING A DETACHABLE SEMICONDUCTOR SUBSTRATE AND FOR OBTAINING A SEMICONDUCTOR ELEMENT

(30) Priorité: 07.10.2002 FR 0212443; 25.04.2003 FR 0350130
(43) Date de publication de la demande: 06.07.2005
(73) Titulaire: Commissariat à l'Énergie Atomique et aux Énergies Alternatives, 75015 Paris (FR)
(72) Inventeur: LAGAHE, Chrystelle, F-38134 Saint-Joseph de Riviere (FR); ASPAR, Bernard, F-38140 Rives (FR); BEAUMONT, Aurélie, F-38120 Saint-Egrève (FR)
(74) Mandataire: Poulin, Gérard
(86) Numéro de dépôt international: PCT/FR2003/050077
(87) Numéro de publication internationale: WO 2004/032183

(56) Documents cités:
- EP-A- 0 961 312
- WO-A-02/05344
- FR-A- 2 748 851
- FR-A- 2 797 347
- FR-A- 2 809 867
- US-A- 5 877 070

## Description

### DOMAINE TECHNIQUE

La présente invention concerne un procédé de réalisation d'un substrat semiconducteur démontable. Elle concerne également un procédé d'obtention d'un élément en matériau semiconducteur.

### ETAT DE LA TECHNIQUE ANTERIEURE

Le document FR-A-2 681 472 (correspondant au brevet américain n° 5 374 5,64) décrit un procédé de fabrication de films minces de matériau semiconducteur. Il divulgue que l'introduction d'un gaz rare ou d'hydrogène dans un substrat est susceptible d'induire, dans certaines conditions, la formation de micro-cavités ou micro-bulles à une profondeur voisine de la profondeur moyenne de pénétration des ions implantés. Par la mise en contact intime de ce substrat, par sa face implantée, avec un raidisseur et la réalisation d'un traitement thermique adapté, il peut s'opérer une interaction entre les micro-cavités ou micro-bulles présentes dans la zone implantée. Cette interaction peut alors conduire à une fracture au niveau de la zone implantée du substrat semiconducteur. Deux parties sont alors obtenues : un film semiconducteur adhérant au raidisseur d'une part et le reste du substrat initialement implanté d'autre part. Le reste du substrat peut être recyclé et réutilisé. Ce procédé permet en particulier de reporter une couche mince de matériau sur un substrat support pouvant être de nature différente. Il permet notamment la fabrication de substrats SOI ("Silicon On Insulator").

Ce procédé peut également s'appliquer à la fabrication d'un film mince de matériau solide autre qu'un matériau semiconducteur, tel que par exemple un matériau conducteur ou diélectrique, cristallin ou pas, comme le divulgue le document FR-A-2 748 850 (correspondant au brevet américain n°6 190 998).

Par ailleurs, le document FR-A-2 748 851 (correspondant au brevet américain n°6 020 252) expose un procédé permettant d'inclure des étapes technologiques nécessitant l'utilisation de températures élevées, par exemple 900°C, entre l'étape d'implantation ionique initiale et l'étape finale de séparation. Ces étapes intermédiaires comportant des traitements thermiques peuvent être effectuées sans dégrader l'état de surface de la face plane de la plaquette et sans générer la fracture au niveau de la zone implantée, qui induirait la séparation de la couche mince superficielle. Elles peuvent par exemple faire partie des opérations de réalisation de composants électroniques. Dans ce cas, l'étape d'implantation ionique, par exemple d'hydrogène, doit être faite dans une gamme de doses appropriées. L'étape de séparation finale pourra alors être effectuée soit par traitement thermique, soit par application d'une contrainte mécanique à la structure soit encore par combinaison de ces deux traitements.

Le document FR-A-2 809 867 divulgue un procédé comprenant une étape d'introduction d'espèces gazeuses selon une couche enterrée dans le substrat, qui mènera à la formation de micro-cavités dans cette couche. La zone implantée enterrée ainsi fragilisée délimite une couche mince avec une face du substrat. Le procédé comporte également une étape d'élimination de tout ou partie des espèces gazeuses de la zone fragilisée. Cette évacuation de la phase gazeuse autorise la réalisation ultérieure de traitements à hautes températures et ce sans induire une déformation de la surface (par exemple sous forme de cloques ou "blisters") ou une séparation totale ou partielle de la couche superficielle. Une étape de surfragilisation de la zone des micro-cavités peut optionnellement être effectuée par la réalisation de traitements thermiques appropriés, par l'application de contraintes mécaniques ou encore par combinaison de ces deux types de traitements. Cette surfragilisation de la zone enterrée pourra par exemple faciliter la séparation finale entre la couche superficielle du substrat et le substrat. L'étape d'implantation des espèces gazeuses est effectuée dans une gamme de doses adaptées permettant d'une part la réalisation d'une fragilisation suffisante de la zone enterrée et d'autre part l'élimination postérieure des espèces gazeuses.

Dans le document FR-A-2 758 907 (correspondant au brevet américain n° 6 316 333), le Procédé décrit permet de reporter une couche de matériau, par exemple du silicium, sur laquelle ont pu être réalisés des composants. Le substrat comprenant la couche processée est préparé de sorte que certaines zones à la surface soient masquées. Les espèces introduites dans ce substrat par une étape d'implantation ionique se trouvent alors localisées dans les zones non masquées. Les zones masquées par contre ne reçoivent pas d'ions. Au niveau des zones implantées, on obtient donc une couche enterrée de défauts spécifiques liés à l'introduction des espèces gazeuses, tels que des micro-bulles, micro-cavités ou encore micro-fissures. Les zones masquées peuvent être choisies de sorte à protéger les zones actives des composants susceptibles de subir une dégradation lors de la traversée des ions implantés. Typiquement, les dimensions des zones masquées sont décrites de l'ordre de 1 µm. La solidarisation ultérieure du substrat comportant la couche processée et comportant des régions localement implantées, suivie d'un traitement de séparation, pouvant notamment comprendre un recuit à une température moyenne (environ 400°C), permet alors de reporter la couche active de composants sur un substrat support. En effet, le développement des cavités et micro-fissures au niveau des zones implantées est apte à provoquer la séparation sur pleine plaque de la couche superficielle.

Les résultats publiés par C.H. Yun et al. ("Transfer of patterned ion-cut silicon layer", Applied Physics Letters, vol 73, n°19, nov. 1998 et "Ion-cut silicon layer transfer with patterned implantation of hydrogen"', Electrochemical Society Proceedings, vol 99-3, p 125) ont montré que les zones masquées lors de l'étape d'implantation peuvent se traduire par des carrés ou des lignes dont les dimensions maximales sont respectivement de l'ordre de 15 µm x 15 µm et 15 µm x 100 µm. Les zones implantées séparant ces motifs masqués doivent au minimum être de 5 µm. Il peut alors s'opérer le transfert de la couche superficielle sur un support, à partir d'un traitement thermique ou par application de forces mécaniques externes à la structure. Les auteurs notent cependant que la couche superficielle reportée comporte des inhomogénéités de reliefs au niveau des zones non implantées. Ces inhomogénéités sont d'autant plus fortes que les dimensions sont importantes (entre 10 et 15 µm). Les auteurs expliquent que ces reliefs irréguliers proviennent de la déviation de la fissure dans les plans de clivage (111) du substrat.

Un autre procédé permet également l'élaboration d'un substrat démontable, capable de supporter un traitement à haute température (environ 1100°C) avant le démontage final de la couche superficielle processée. Ce procédé est basé sur une implantation locale, rendue possible par l'utilisation d'un masque au moment de l'introduction des ions (hydrogène et/ou autres espèces telles que par exemple des gaz rares). La taille des régions implantées est étudiée de sorte que les traitements thermiques ultérieurs de fragilisation de la zone enterrée et/ou requis pour tout ou partie des étapes de réalisation des composants n'induisent pas de dégradation de la surface. Cette contrainte est liée aux étapes ultérieures d'élaboration de composants, par exemple microélectroniques, qui nécessitent un parfait état de surface.

L'obtention de substrats démontables, c'est-à-dire comprenant une couche superficielle délimitée par la surface du substrat et par une zone enterrée fragilisée, lesdits substrats étant compatibles avec la mise en oeuvre d'étapes technologiques destinées à fabriquer des composants et pouvant requérir des traitements à hautes températures, présente un intérêt croissant. Les applications photovoltaïques ont une exigence supplémentaire qui est l'utilisation d'un procédé à faible coût.

Le document FR-A-2 748 850, cité ci-dessus, propose une méthode de fragilisation d'un substrat selon une couche enterrée, par introduction en faible dose d'une espèce gazeuse (par exemple l'hydrogène). La dose implantée doit être choisie de telle sorte qu'un recuit thermique n'induise pas de déformation ou d'exfoliation de surface. Selon les forces mécaniques applicables pour induire la séparation, le stade de fragilisation atteint au niveau de la zone implantée peut alors se révéler insuffisant. Il peut alors être intéressant d'augmenter le niveau de fragilisation de la zone implantée.

D'après le procédé décrit dans le document FR-A-2 809 867, cité ci-dessus, l'introduction d'une dose contrôlée permet à la fois de fragiliser la zone enterrée puis d'évacuer le gaz, cela afin de limiter un effet de pression lors d'une montée en température. On n'a donc pas de déformation ou d'exfoliation de la surface lors d'étapes technologiques à hautes températures. Cette technique nécessite un contrôle rigoureux de la dose et de l'homogénéité de dose des espèces implantées. Il peut se révéler intéressant de relâcher des contraintes technologiques relatives à une fenêtre étroite de paramètres d'implantation.

Le document FR-A-2 758 907, cité ci-dessus, propose une introduction locale d'espèces gazeuses après réalisation des composants dans la couche superficielle du substrat. L'introduction de ces espèces mène à la formation d'une couche enterrée discontinue de micro-cavités susceptibles de générer la fracture après solidarisation du substrat processé sur un substrat support. Le substrat est donc fragilisé après la réalisation des différentes étapes technologiques de fabrication des composants. La taille accessible des zones à masquer (qui correspondent aux zones actives des composants) peut se révéler limitative selon les applications visées. Par exemple, pour des tailles de composants de plusieurs dizaines de µm à plusieurs centaines de µm, cette technique est difficile à mettre en oeuvre. De plus, selon la technologie de réalisation des composants utilisée, l'épaisseur de la couche active, c'est-à-dire comportant les composants, peut atteindre plusieurs µm (par exemple, environ 50 µm pour les cellules photovoltaïques en silicium). L'introduction des espèces gazeuses à une forte profondeur tout en protégeant efficacement les zones par masquage peut alors s'avérer délicate, notamment à cause des équipements nécessaires (implanteurs spécifiques, accélérateurs) ainsi que coûteuse, par exemple pour les applications photovoltaïques.

Un substrat démontable peut également être réalisé selon le procédé décrit ci-dessus et utilisant un masque au moment de l'introduction des ions. Ce procédé met en oeuvre une étape intermédiaire de masquage préalable à l'implantation qui permettra par un confinement latéral des micro-fissures enterrées de limiter fortement l'apparition de déformations sous forme de cloques à la surface du substrat. L'état de surface de substrat est alors parfaitement compatible avec différentes étapes de réalisation de composants, par exemple microélectroniques. Par contre, ce procédé peut présenter le désavantage d'un coût élevé, notamment dans des domaines d'application tels que le photovoltaïque.

### EXPOSÉ DE L'INVENTION

La présente invention a été conçue dans un souci de réduction des coûts, mais en gardant pour objectif l'obtention d'une couche superficielle processée pouvant être séparée ou détachée de son substrat sans casse ni détérioration de la structure.

L'invention a donc pour objet un procédé de réalisation d'un substrat semiconducteur démontable, comprenant les étapes suivantes :
- introduction d'espèces gazeuses dans le substrat selon des conditions permettant la constitution d'une couche fragilisée par la présence dans cette couche de micro-cavités et/ou de micro-bulles, une couche mince de matériau semiconducteur étant ainsi délimitée entre la couche fragilisée et une face du substrat,
- traitements thermique du substrat pour augmenter le niveau de fragilisation de la couche fragilisée, ce traitement thermique étant mené jusqu' à l'apparition de déformation locales de ladite face du substrat sous ferme de cloques mais sans générer d'exfoliations de la couche mince lors de cette étape,
- épitaxie de matériau semiconducteur sur ladite face du substrat pour fournir au moins une couche épitaxiée sur ladite couche mince sans générer d'exfoliations de la couche mince lors de cette étape.

L'introduction d'espèces gazeuses peut être réalisée par implantation ionique ou implantation par immersion plasma.

Avant l'étape de traitement thermique du substrat, il peut être prévu une étape de formation d'un épaississeur dont l'épaisseur est suffisamment grande pour ne pas générer d'exfoliations dans la couche mince et suffisamment petite pour éviter la séparation du substrat au niveau de la couche fragilisée lors de l'étape de traitement thermique de la couche fragilisée. L'épaississeur peut alors être éliminé totalement ou partiellement avant l'étape d'épitaxie.

Il peut être prévu une étape supplémentaire de soumission de la couche épitaxiée à au moins une étape de réalisation de composants. Il peut s'agir d'une étape de réalisation de composants photovoltaïques.

Il peut être également prévu une étape supplémentaire de formation d'une couche de protection sur la couche épitaxiée, cette couche de protection étant destinée à protéger la couche épitaxiée d'une attaque chimique destinée à la séparation du substrat au niveau de la couche fragilisée.

L'invention a aussi pour objet un procédé d'obtention d'un élément de matériau semiconducteur, caractérisé en ce qu'il comprend les étapes suivantes :
- fourniture d'un substrat semiconducteur démontable obtenu par le procédé de réalisation d'un substrat semiconducteur démontable tel que décrit ci-dessus,
- démontage du substrat semiconducteur démontable par détachement de ce substrat au niveau de la couche fragilisée, le détachement étant soit total pour fournir un élément de matériau semiconducteur formant membrane et constitué de la couche mince de matériau semiconducteur et de la couche épitaxiée, soit partiel pour fournir un ou plusieurs éléments de matériau semiconducteur formant un ou plusieurs composants et constitué(s) d'une partie de la couche mince de matériau semiconducteur et de la couche épitaxiée.

Il peut aussi être prévu une étape supplémentaire de fixation de la couche épitaxiée sur un support avant l'étape de démontage.

Le détachement peut résulter de l'application d'une contrainte en traction et/ou d'une contrainte en cisaillement. Il peut résulter de la mise en oeuvre d'une étape d'introduction d'espèces gazeuses supplémentaires dans la couche fragilisée, puis d'une étape de contrainte mécanique et/ou de traitement thermique de la couche fragilisée. Il peut aussi résulter de l'application d'une contrainte d'ouverture au niveau de la couche fragilisée. Il peut encore résulter d'une attaque chimique de la couche fragilisée. Il peut encore résulter d'une combinaison de ces méthodes.

L'étape de fourniture d'un substrat semiconducteur démontable peut comprendre la fourniture d'un substrat qui a déjà été démonté et qui est obtenu par le procédé de réalisation d'un substrat semiconducteur démontable ci-dessus et sans conditionnement préalable de surface.

### BREVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés par lesquels :
- la figure 1 est une vue en coupe transversale d'un substrat semiconducteur soumis à une implantation ionique destinée à former une couche enterrée fragilisée, selon l'invention ;
- la figure 2 est une vue en coupe transversale du substrat semiconducteur de la figure 1 ayant subi un traitement thermique permettant d'augmenter le niveau de fragilisation de la couche enterrée fragilisée, selon l'invention ;
- la figure 3 est une vue en coupe transversale du substrat semiconducteur de la figure 2 après l'épitaxie d'une couche de matériau semiconducteur sur toute la face implantée du substrat, selon l'invention ;
- la figure 4 est une vue en coupe transversale du substrat semiconducteur de la figure 2 après l'épitaxie d'une couche de matériau semiconducteur sur une partie de la face implantée du substrat, selon l'invention ;
- la figure 5 est une vue en coupe transversale du substrat semiconducteur de la figure 3 après réalisation de composants dans la couche épitaxiée, selon l'invention ;
- la figure 6 est une vue en coupe transversale du substrat semiconducteur de la figure 5 après fixation de la couche épitaxiée sur un support, selon l'invention ;
- la figure 7 est une vue en coupe transversale du substrat semiconducteur fixé à son support, comme montré sur la figure 6, au cours de l'étape de séparation, selon l'invention.

### EXPOSÉ DÉTAILLÉ DE MODES DE RÉALISATION PARTICULIERS

Le procédé selon l'invention s'applique en particulier au domaine d'applications photovoltaïques. Il permet la réalisation d'un substrat (en particulier en silicum) comportant une couche fragilisée enterrée, qui pourra subir les différentes étapes de croissance épitaxiale et d'élaboration des cellules, propres à l'application photovoltaïque visée, puis autorisera la séparation finale entre la couche superficielle processée et le reste du substrat.

Ce procédé est basé sur l'implantation d'espèces gazeuses telles que des ions d'hydrogène et/ou de gaz rares, aptes à créer, autour de la profondeur de concentration maximale, une zone fragilisée par des micro-cavités, "platelets" et/ou micro-bulles. Un traitement thermique permettant d'augmenter le niveau de fragilisation de la couche fragilisée est réalisée. Ce traitement thermique sera appelé par la suite traitement thermique de fragilisation. Dans certaines conditions, ce traitement thermique de fragilisation imposé au substrat implanté a pour conséquence la formation de cavités et/ou de micro-fissures dans la zone enterrée fragilisée entraînant l'apparition de cloques ou bulles ou "blisters" à la surface du substrat.

Selon le procédé de l'invention, les conditions d'implantation (dont les paramètres principaux sont l'énergie, la dose et la température) ainsi que les paramètres du traitement thermique de fragilisation et des différentes étapes optionnelles ultérieures de préparation du substrat (traitements thermiques, dépôts de couches, etc.) doivent être choisis en fonction de la nature du substrat (nature du matériau, orientation cristalline...), de sorte qu'il n'apparaisse pas d'exfoliation de la couche superficielle. Par exfoliation, on entend un détachement partiel de la couche mince au niveau de la zone fragilisée. De la même façon, au cours des étapes technologiques propres à l'application visée, par exemple, au cours d'une étape de croissance épitaxiale de la couche de silicium nécessaire à la réalisation de cellules solaires, aucune exfoliation ne sera générée.

Après tout ou partie de la réalisation des composants photovoltaïques, et en respectant certaines mises en oeuvre décrites par la suite, la couche superficielle processée (environ 50 µm) pourra être désolidarisée du substrat initial par fissuration au niveau de la zone fragilisée par les micro-cavités et/ou micro-fissures.

Le procédé débute par la création d'une couche enterrée fragilisée qui autorisera après la réalisation d'étapes technologiques, la séparation entre une couche superficielle et le reste du substrat. Elle est basée sur l'introduction dans le substrat d'espèces gazeuses telles que l'hydrogène et/ou autres gaz rares (hélium..) par une technique permettant une localisation contrôlée des espèces en profondeur (par exemple l'implantation ionique, l'implantation par immersion plasma...). Une telle implantation permet de former une zone enterrée fragilisée typiquement composée de micro-cavités, "platelets" et/ou micro-bulles. Cette zone enterrée perturbée délimite avec la surface du substrat une couche superficielle.

Dans le but d'augmenter le niveau de fragilisation de la zone implantée, des étapes optionelles de préparation du substrat comportant par exemple, un traitement thermique et/ou un dépôt épaississeur pourront être réalisés sur le substrat avant le traitement thermique de fragilisation.

En effet, sous activation thermique, les micro-cavités et/ou "platelets", générés lors de l'implantation par exemple d'ions d'hydrogène, vont suivre une loi de croissance. Ainsi, si la dose implantée est suffisante, l'effet cumulé de l'augmentation de la taille des cavités et/ou des micro-fissures et de la pression de gaz dans celles-ci est l'apparition de déformations locales de la couche superficielle sous forme de cloques.

Les caractéristiques (morphologie, taille, densité) de ces micro-fissures et/ou cavités traduisent l'état de fragilisation de la zone implantée.

Selon une variante du traitement de fragilisation, on peut réaliser un dépôt d'oxyde à la surface du substrat implanté avant tout traitement thermique. Celui-ci jouera un rôle mécanique d'épaississeur qui permet aux micro-fissures de se développer latéralement selon de plus grandes dimensions, sous l'effet d'un recuit thermique adéquat. Des caractéristiques de micro-fissures favorables à une plus forte fragilisation pourront être obtenues par l'ajout de cette couche déposée.

Pour un substrat donné, les paramètres d'implantation, du traitement thermique de fragilisation ainsi que les paramètres de conditionnement du substrat (traitements thermiques, dépôt de couches agissant comme épaississeurs...), dictent les taille et densité de cloques en surface du substrat, c'est-à-dire également les taille et densité de micro-fissures et/ou cavités sous-jacentes, contenues dans la zone implantée.

Le niveau de fragilisation du substrat peut ainsi être paramétré en fonction des conditions d'implantation et des caractéristiques des traitements ultérieurs.

Ainsi pour un substrat donné, il est nécessaire de choisir les conditions d'implantation (énergie, dose, température) de sorte que :
- la réalisation d'un traitement de fragilisation adéquat mène effectivement à l'obtention de micro-fissures de grande dimension, pouvant générer des cloques à la surface du substrat. Cependant, ce traitement ne devra en aucun cas générer des exfoliations de la couche superficielle.
- tout traitement ultérieur, lié aux étapes technologiques propres à l'application visée, par exemple l'épitaxie dans la gamme des 550 C - 1100° C, n'induise pas d'exfoliation locale de la couche.

Le procédé selon l'invention associe des conditions d'implantation et des traitements de fragilisation permettant d'éviter l'exfoliation locale de la couche superficielle avant et après les différentes étapes technologiques relatives à l'application visée.

L'ensemble des conditions d'implantation et des traitements permettant d'augmenter la fragilisation doit permettre l'obtention d'un substrat comportant des micro-fissures localisées dans la zone implantée, donnant lieu à l'apparition de cloques à sa surface. Ces micro-fissures sont aléatoirement réparties dans le plan enterré de fragilisation et leur taille suit une loi de distribution gaussienne. Cet état de fragilisation est tel que tout traitement supplémentaire imposé au substrat, dont notamment les traitements à hautes températures, n'induit pas d'exfoliation locale de la couche superficielle délimitée par la zone implantée et la surface du substrat, par exemple au niveau d'une ou plusieurs micro-fissures.

Il est important de noter que la morphologie, la taille et la densité des micro-fissures et cavités présentes dans la couche fragilisée peut être variable selon les traitements ultérieurs imposés au substrat fragilisé. Les forts budgets thermiques pour lesquels la reconstruction du matériau constituant le substrat est significative, ont une influence notable sur le changement morphologique des micro-fissures formées après l'implantation, suivie d'un traitement de fragilisation requérant un faible budget thermique. Après de forts budgets thermiques, ces micro-fissures et/ou cavités évoluent vers des formes polyédriques stables. On note en particulier une reconstruction de type polyédrique des bords de fissures. Leurs tailles et densités dépendent aussi fortement du budget thermique imposé au substrat fragilisé. On peut remarquer que l'étape de fragilisation peut également comporter un traitement thermique à haute température, de sorte à transformer les micro-fissures et/ou cavités présentes dans la zone implantée en objets stables (évacuation de tout ou partie des espèces gazeuses et reconstruction au moins partielle des bords de fissures). Ceci a pour but d'éviter tout phénomène d'exfoliation au cours des étapes technologiques d'épitaxie et/ou de réalisation de composant.

A ce stade, et pour permettre l'élaboration de composants par exemple photovoltaïques, la croissance épitaxiale d'une couche de silicium épaisse (jusqu'à environ 50 µm), pourra être effectuée sur le substrat cloqué. Le relief "doux" des cloques en surface (typiquement d'un diamètre allant de quelques µm à quelques dizaines de µm et dont la déformation maximale peut atteindre quelques centaines de nanomètres) permet l'obtention par épitaxie de couches épaisses de silicium monocristallin de bonne qualité pour l'application visée.

Différentes étapes d'élaboration de composants de type photovoltaïque pourront alors être effectuées.

La suite du procédé correspond à la séparation finale entre la couche superficielle et le substrat initial. Cette séparation se fera au niveau de la zone enterrée fragilisée.

Cette étape peut être effectuée par application d'une contrainte en traction, en cisaillement ou en mode mixte impliquant de la traction et du cisaillement, à la zone fragilisée.

Selon un premier mode de réalisation, la couche superficielle processée pourra être séparée de son substrat-source, générant ainsi une membrane autoportée. Cette membrane pourra être séparée sur la surface totale du substrat ou encore localement au niveau d'un composant ou d'un ensemble de composants, par l'application d'une contrainte d'ouverture au niveau de la zone fragilisée.

Selon un second mode de réalisation, un substrat support de faible coût pourra être lié par l'intermédiaire d'une couche adhésive (polymère, résine, céramique, métallique ou autre...) à la couche processée de silicium. La séparation, par exemple par application de contraintes en traction et/ou en cisaillement et/ou selon un mode mixte à la structure collée peut alors s'effectuer au niveau de la zone enterrée fragilisée.

On obtient alors :
- le substrat initial d'une part, pelé d'une couche mince (cette couche étant la zone délimitée par la zone implantée et la surface du substrat initial),
- et le support d'autre part, comportant la membrane de matériau semiconducteur (par exemple du silicium) processée.

Selon une variante du procédé et pour faciliter la désolidarisation finale de la membrane du substrat initial, une attaque chimique pourra être réalisée. Une solution de type SECCO^{®} a la propriété d'attaquer le silicium et plus préférentiellement les zones de silicium contraint et/ou ayant subi des déformations plastiques et/ou perturbé par la présence d'inclusions, structurations ou autres transformations morphologiques. Ainsi, la zone fragilisée comportant des micro-fissures et/ou des cavités dont la taille latérale peut varier d'environ quelques dizaines de nanomètres à quelques dizaines de µm, sera une zone privilégiée d'attaque de la solution SECCO^{®}. Il est de cette façon possible d'initier une désolidarisation de la couche superficielle processée du substrat initial, par une consommation localisée progressive par la solution chimique de la zone fragilisée enterrée. Selon cette variante de l'étape de séparation, il sera nécessaire de réaliser le dépôt d'une couche de protection, notamment sur la face supérieure processée du substrat, de sorte à éviter la dégradation des cellules et/ou composants réalisés.

D'autres solutions permettant la gravure du matériau semiconducteur au niveau de la zone fragilisée peuvent également être utilisées à condition de protéger de manière efficace les parties processées du substrat. On peut notamment citer le TMAH, le KOH si le matériau semiconducteur est du silicium.

Selon une variante du procédé, cette étape consistant en une attaque localisée au niveau de la zone fragilisée, peut être effectuée avant la réalisation des composants (par exemple cellules photovoltaïques). Ainsi, il ne sera pas nécessaire de prendre des précautions pour protéger la face processée du substrat fragilisé.

Cette technique d'attaque chimique préférentielle peut être utilisée seule pour séparer totalement la membrane processée de son substrat initial, cela dans le but d'obtenir une couche autoportée ou encore dans le but de reporter cette membrane sur un support mécanique économique.

Selon une variante, cette technique d'attaque chimique peut être utilisée conjointement avec une technique de séparation mécanique par application de forces externes telles par exemple que la traction. Dans ce cas de figure, l'attaque chimique présentera l'avantage d'initier et de localiser la fissure au niveau de la zone enterrée fragilisée et ainsi de faciliter la désolidarisation finale.

Selon une variante, on pourra soumettre le substrat à des traitements par ondes acoustiques (ultrasons, nanovibrations, ...).

Selon une variante du procédé, on peut réaliser un traitement destiné à faire diffuser des espèces gazeuses, par exemple de l'hydrogène, par la face avant ou la face arrière du substrat processé. Les techniques utilisées peuvent être par exemple l'hydrogénation plasma, ou autres méthodes d'introduction d'espèces gazeuses par diffusion. Cette étape peut permettre d'augmenter le niveau de fragilisation de la zone enterrée de micro-fissures et/ou micro-cavités. Les espèces introduites dans le matériau sont préférentiellement piégées au niveau de la zone de micro-fissures.

La séparation finale peut alors être réalisée par un traitement thermique adapté et/ou par application d'une contrainte mécanique adéquate et/ou par un traitement comprenant à la fois un traitement thermique et un traitement mécanique.

Le substrat initial pelé d'une couche superficielle peut alors être recyclé pour la réalisation d'un autre substrat à fragiliser.

On notera que, de façon avantageuse, aucun traitement de conditionnement de surface (par exemple un polissage) ne sera nécessaire sur ce substrat recyclé. L'introduction d'espèces gazeuses pourra être faite directement dans le substrat dont la surface présente une micro-rugosité liée à l'étape de disociation.

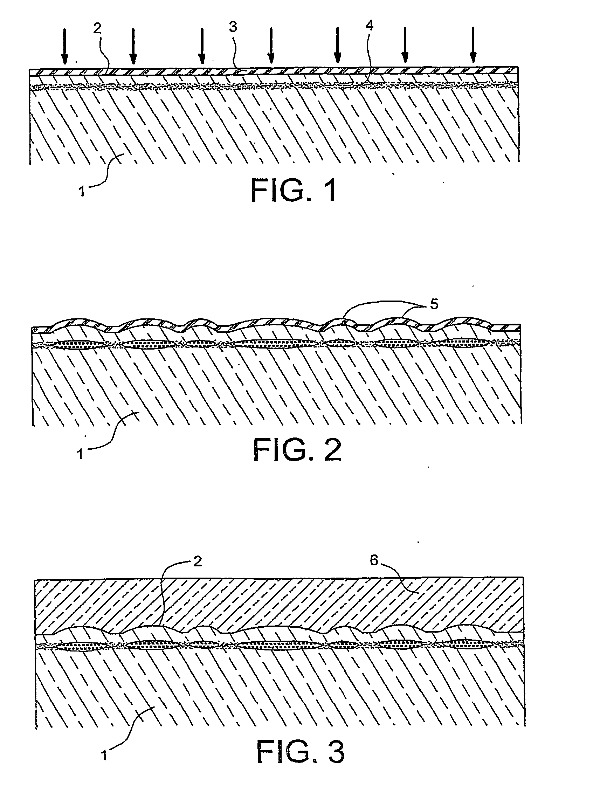

La figure 1 est une vue en coupe transversale d'un substrat semiconducteur 1, dans cet exemple il s'agit d'un substrat en silicium, qui va être soumis au procédé de l'invention, selon un premier exemple de mise en oeuvre. La face principale 2 du substrat de silicium 1 est recouverte d'une couche d'oxyde de silicium 3.

Une implantation ionique d'hydrogène, représentée symboliquement par des flèches sur la figure 1, est effectuée dans le substrat 1 au travers de la couche d'oxyde 3. Le faisceau d'implantation possède une énergie de 210 keV et une dose de 6.10¹⁶H⁺/cm². Il provoque la formation d'une couche enterrée fragilisée 4 comprenant des micro-bulles et des micro-cavités.

Un recuit à 550°C pendant 30 minutes est effectué sur ce substrat afin d'augmenter le niveau de fragilisation de la zone implantée. En effet, sous activation thermique, les cavités induites par l'implantation suivent une loi de croissance pour former des micro-fissures et/ou des cavités de plus grande taille qui provoque l'apparition de cloques 5 à la surface du substrat comme le montre la figure 2.

La surface oxydée du substrat est ensuite désoxydée, puis une étape technologique d'épitaxie de silicium en phase liquide ou en phase vapeur est effectuée. La figure 3 montre la présence d'une couche épitaxiée 6 sur la face principale 2 du substrat 1. L'épaisseur de la couche épitaxiée 6 peut être de 50 µm. L'épitaxie en phase liquide peut être faite pour une température d'environ 950°C pendant 2 heures. L'épitaxie en phase vapeur peut être faite autour de 1100°C pendant 1 heure.

Selon un deuxième exemple de mise en oeuvre de l'invention, l'implantation ionique d'hydrogène est effectuée pour une énergie de 76 keV et une dose de 6.10¹⁶H⁺/cm² à travers une couche d'oxyde de silicium de 400 nm recouvrant un substrat de silicium. Un dépôt par PECVD est alors effectué pour obtenir une couche d'oxyde de silicium supplémentaire de 3 µm d'épaisseur. Ce substrat peut ensuite subir un traitement de fragilisation tel qu'un recuit à température croissante partant de 400°C jusqu'à 1100°C, la montée en température se faisant par exemple à 3°C/min et la durée de traitement à 1100°C étant d'une heure. Ce traitement a pour effet de faire croître les cavités et/ou micro-fissures au niveau de la zone implantée puis de stabiliser ces cavités et/ou micro-fissures à haute température afin qu'il ne s'opère pas de modification de l'état de surface du substrat lors du retrait de la couche épaisse d'oxyde ou au cours des étapes technologiques ultérieures.

La surface oxydée du substrat est ensuite désoxydée, préalablement à une étape technologique d'épitaxie en phase liquide ou vapeur de silicium, d'une épaisseur comprise entre 20 µm et 50 µm.

Selon un troisième exemple de mise en oeuvre de l'invention, l'implantation d'hydrogène est effectuée par immersion plasma pour une énergie de 76 keV et une dose de 6.10¹⁶H+/cm² à travers une couche d'oxyde de silicium de 400 nm recouvrant un substrat de silicium. Un dépôt par PECVD est alors effectué pour obtenir une couche d'oxyde de silicium supplémentaire de 3 µm d'épaisseur. Ce substrat peut ensuite subir un traitement de fragilisation tel qu'un recuit à température croissante partant de 400°C jusqu'à 1100°C, la montée en température se faisant par exemple à 3°C/min.

La surface oxydée du substrat est ensuite partiellement désoxydée. L'oxyde est par exemple retiré sur la partie centrale du substrat mais demeure sur une couronne en bord de substrat, d'une largeur pouvant aller de quelques centaines de µm à quelques mm. Une étape d'épitaxie en phase liquide pour obtenir une couche épitaxiée d'épaisseur comprise entre 20 µm et 50 µm est ensuite effectuée.

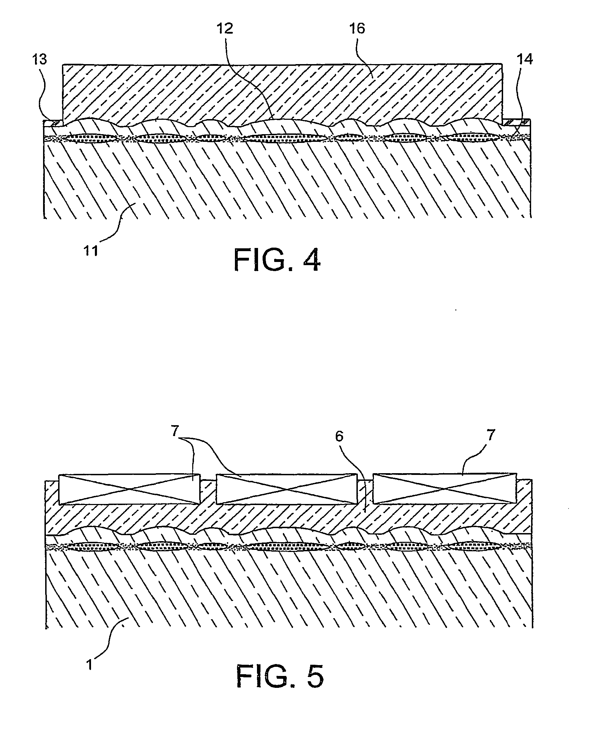

La figure 4 illustre ce troisième exemple de mise en oeuvre de l'invention. Elle montre un substrat en silicium 11 comportant une couche enterrée fragilisée 14, une couche d'oxyde 13 subsistant en couronne sur le substrat 11 et une couche épitaxiée 16 déposée sur la partie de la face 2 du substrat non recouverte d'oxyde. On voit bien que sur la couronne 13 la reprise d'épitaxie ne s'est pas faite.

Selon un quatrième exemple de mise en oeuvre de l'invention, l'implantation ionique d'hydrogène est effectuée pour une énergie de 210 keV et une de dose de 7.10¹⁶H⁺/cm² à travers une couche d'oxyde de silicium de 200 nm recouvrant un substrat de silicium. Un dépôt par PECVD est alors effectué pour obtenir une couche d'oxyde de silicium supplémentaire de 10 µm d'épaisseur.

Ce substrat pourra ensuite subir un recuit de fragilisation à 450°C pendant 14 heures, suivi d'une montée à 3°C/min jusqu'à 1100°C.

La surface oxydée du substrat est ensuite partiellement désoxydée. L'oxyde est par exemple retiré sur la partie centrale du substrat mais demeure sur une couronne en bord de substrat, d'une largeur pouvant aller de quelques centaines de µm à quelques mm. Une étape d'épitaxie en phase vapeur de silicium pour obtenir une couche épitaxiée d'épaisseur comprise entre 20 et 50 µm est ensuite effectuée.

Après cette étape, le substrat comprend une partie centrale sur laquelle la reprise d'épitaxie de silicium monocristallin a été possible du fait de la désoxydation préalable à l'épitaxie. Le substrat comprend aussi, sur sa partie périphérique, la couronne d'oxyde de silicium sur laquelle la reprise d'épitaxie s'est opérée sous forme polycristalline.

Selon un cinquième exemple de mise en oeuvre de l'invention, l'implantation d'hydrogène par immersion plasma est effectuée pour une énergie de 76 keV et une dose de 6.10¹⁶H⁺/cm² à travers une couche d'oxyde de silicium de 400 nm recouvrant un substrat de silicium poli double face. L'implantation est effectuée sur les deux faces principales du substrat. Un dépôt d'oxyde PECVD de 3 µm est réalisé sur ce substrat implanté double face. Ce substrat subit ensuite un traitement de fragilisation tel qu'un recuit à température croissante partant de 400°C jusqu'à 1100°C, la montée en température se faisant par exemple à 3°C/min.

Les surfaces oxydées du substrat sont ensuite partiellement désoxydées. En particulier, l'oxyde est retiré sur une partie centrale des deux faces du substrat mais demeure sur une couronne en bord d'une largeur pouvant aller centaines de µm à quelques mm. Une étape technologique d'épitaxie en phase liquide, d'une épaisseur comprise entre 20 µm et 50 µm est ensuite effectuée, sur les deux faces du substrat. Après cette étape, le substrat comprend une partie centrale sur laquelle la reprise d'épitaxie a été possible du fait de la désoxydation préalable à l'épitaxie. Le substrat comprend, sur la partie périphérique de ses faces, la couronne d'oxyde PECVD déposé sur laquelle la reprise d'épitaxie n'a pas été possible.

Selon un sixième exemple de mise en oeuvre de l'invention, l'implantation ionique d'hydrogène est effectuée pour une énergie de 52 keV et une dose de 5,5.10¹⁶ H⁺/cm² à travers une couche d'oxyde de silicium de 200 nm recouvrant un substrat de silicium. Un dépôt par PECVD est alors effectué pour obtenir une couche d'oxyde supplémentaire de 5 µm d'épaisseur. Le substrat pourra ensuite subir un recuit de fragilisation à 500°C pendant 4 heures. La surface oxydée du substrat est ensuite désoxydée totalement. Une étape d'épitaxie en phase liquide à 600°C pourra alors être réalisée dans le but d'obtenir une couche épitaxiée comprise entre 20 µm et 50 µm

Quelle que soit la mise en oeuvre de l'invention, des étapes technologiques de réalisation de composants, par exemple photovoltaïques, peuvent être mises en oeuvre. La figure 5 montre des composants 7 réalisés dans la couche épitaxiée 6 du substrat représenté à la figure 3. Si l'épitaxie a été effectuée sur les deux faces principales du substrat, des composants peuvent alors être réalisés dans les deux couches épitaxiées.

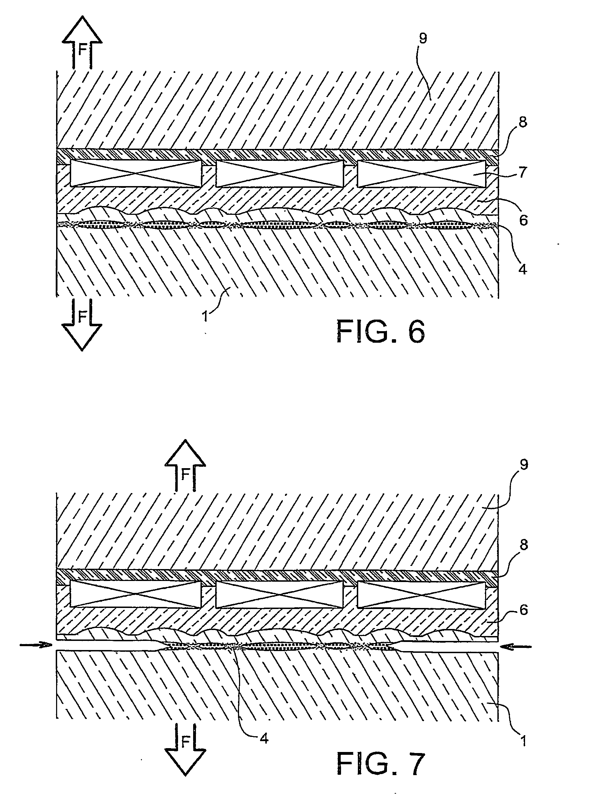

Le substrat ainsi processé est ensuite solidarisé au moyen d'une colle céramique 8 par exemple sur un support mécanique 9 tel qu'un substrat en céramique, en verre ou en mullite comme le montre la figure 6. L'insertion dans la région de la couche fragilisée 4, d'un outil adapté comportant par exemple une lame en biseau permettra alors de découper au niveau de la zone enterrée implantée, séparant ainsi la couche processée 6 de son substrat initial 1, et la laissant solidaire du substrat support 9. Le substrat initial 1 pourra ensuite être recyclé en nouveau substrat à fragiliser.

Le substrat processé du deuxième mode de mise en oeuvre de l'invention peut être solidarisé au moyen d'une colle polymère sur un support mécanique tel qu'un substrat plastique. L'immersion de la structure collée dans une solution, par exemple de SECCO^{®}, provoque l'attaque préférentielle du silicium polycristallin, de la couronne d'oxyde et de la zone enterrée fragilisée, ce qui peut amorcer la séparation entre la couche processée de son substrat initial. La séparation peut s'opérer en totalité selon cette voie chimique ou encore être assistée par l'application d'une contrainte mécanique ou encore être relayée par une voie purement mécanique d'ouverture mettant en oeuvre des contraintes en tension et/ou en cisaillement comme cela est indiqué par les flèches F sur les figures 6 et 7. Le substrat initial pourra ensuite être recyclé en nouveau substrat à fragiliser.

Le substrat processé du troisième mode de mise en oeuvre de l'invention peut être solidarisé au moyen d'une colle polymère sur un support mécanique tel qu'un substrat en plastique. La structure collée peut alors être immergée dans un bain de HF. Cela a pour conséquence d'attaquer la couche d'oxyde périphérique présente sur le substrat fragilisé processé. Ainsi, l'application de la contrainte lors de l'insertion d'une lame est mieux localisée au niveau de la zone fragilisée. On aboutit alors à la séparation entre la couche processée et son substrat initial. Le substrat initial pourra ensuite être recyclé en nouveau substrat à fragiliser.

Le substrat processé du quatrième mode de mise en oeuvre de l'invention peut être solidarisé au moyen d'une colle polymère sur un support mécanique tel qu'un substrat plastique. L'immersion de la structure collée dans une solution, par exemple de SECCO^{®}, provoque l'attaque préférentielle du silicium polycristallin, de la couronne d'oxyde et de la zone enterrée fragilisée, ce qui peut amorcer la séparation entre la couche processée de son substrat initial. La séparation peut s'opérer en totalité selon cette voie chimique ou encore être assistée par l'application d'une contrainte mécanique ou encore être relayée par une voie purement mécanique d'ouverture mettant en oeuvre des contraintes en tension et/ou en cisaillement comme cela est indiqué par les flèches F sur les figures 6 et 7. Le substrat initial pourra ensuite être recyclé en nouveau substrat à fragiliser.

Le substrat processé du cinquième mode de mise en oeuvre de l'invention peut être solidarisé au moyen d'une colle polymère sur un support mécanique tel qu'un substrat plastique. La structure collée est alors immergée dans un bain de HF. Cela a pour conséquence d'attaquer la couche d'oxyde périphérique présente sur chacune des faces du substrat fragilisé processé. L'application de la contrainte lors de l'insertion d'une lame sera mieux localisée au niveau de la zone fragilisée. Cette contrainte sera successivement ou conjointement appliquée dans la région de la couche fragilisée d'une et de l'autre face du substrat. On aboutit alors à la séparation entre les couches processées et le substrat initial. Le substrat initial pourra ensuite être recyclé en nouveau substrat à fragiliser.

## Revendications

1. Procédé de réalisation d'un substrat semiconducteur démontable, comprenant les étapes suivantes :
- introduction d'espèces gazeuses dans le substrat (1) selon des conditions permettant la constitution d'une couche fragilisée (4) par la présence dans cette couche de micro-cavités et/ou de micro-bulles, une couche mince de matériau semiconducteur étant ainsi délimitée entre la couche fragilisée (4) et une face (2) du substrat,
- traitement thermique du substrat pour augmenter le niveau de fragilisation de la couche fragilisée (4), ce traitement thermique étant mené jusqu'à l'apparition de déformations locales de ladite face (2) du substrat (1) sous forme de cloques mais sans générer d'exfoliations de la couche mince lors de cette étape,
- épitaxie de matériau semiconducteur (6) sur ladite face du substrat pour fournir au moins une couche épitaxiée sur ladite couche mince sans générer d'exfoliations de la couche mince lors de cette étape.

2. Procédé selon la revendication 1, **caractérisé en ce que** l'introduction d'espèces gazeuses est réalisée par implantation ionique ou implantation par immersion plasma.

3. Procédé selon la revendication 2, **caractérisé en ce que** l'introduction d'espèces gazeuses étant réalisée par implantation par immersion plasma, le procédé est appliqué sur deux faces du substrat.

4. Procédé selon la revendication 1, **caractérisé en ce que**, avant l'étape de traitement thermique du substrat, il est prévu une étape de formation d'un épaississeur dont l'épaisseur est suffisamment grande pour ne pas générer d'exfoliations dans la couche mince et suffisamment petite pour éviter la séparation du substrat au niveau de la couche fragilisée lors de l'étape de traitement thermique du substrat.

5. Procédé selon la revendication 4, **caractérisé en ce que** l'épaississeur est éliminé totalement ou partiellement avant l'étape d'épitaxie.

6. Procédé selon la revendication 1, **caractérisé en ce qu'**il est prévu une étape supplémentaire de soumission de la couche épitaxiée à au moins une étape de réalisation de composants (7).

7. Procédé selon la revendication 6, **caractérisé en ce que** ladite étape de réalisation de composants (7) est une étape de réalisation de composants photovoltaïques.

8. Procédé selon l'une quelconque des revendications précédentes, **caractérisé en ce qu'**il est prévu une étape supplémentaire de formation d'une couche de protection sur la couche épitaxiée, cette couche de protection étant destinée à protéger la couche épitaxiée d'une attaque chimique destinée à la séparation du substrat au niveau de la couche fragilisée.

9. Procédé d'obtention d'un élément de matériau semiconducteur, **caractérisé en ce qu'**il comprend les étapes suivantes :
- fourniture d'un substrat semiconducteur démontable obtenu par le procédé selon l'une quelconque des revendications 1 à 8,
- démontage du substrat semiconducteur démontable par détachement de ce substrat au niveau de la couche fragilisée, la séparation étant soit totale pour fournir un élément de matériau semiconducteur formant membrane et constitué de la couche mince de matériau semiconducteur et de la couche épitaxiée, soit partielle pour fournir un ou plusieurs éléments de matériau semiconducteur formant un ou plusieurs composants et constitué(s) d'une partie de la couche mince de matériau semiconducteur et de la couche épitaxiée.

10. Procédé selon la revendication 9, **caractérisé en ce qu'**il est prévu une étape supplémentaire de fixation de la couche épitaxiée sur un support avant l'étape de démontage.

11. Procédé selon la revendication 9, **caractérisé en ce que** le détachement résulte de l'application d'une contrainte en traction et/ou d'une contrainte en cisaillement.

12. Procédé selon la revendication 9, **caractérisé en ce que** le détachement résulte de la mise en oeuvre d'une étape d'introduction d'espèces gazeuses supplémentaires dans la couche fragilisée, puis d'une étape de contrainte mécanique et/ou de traitement thermique de la couche fragilisée.

13. Procédé selon la revendication 9, **caractérisé en ce que** le détachement résulte de l'application d'une contrainte d'ouverture au niveau de la couche fragilisée.

14. Procédé selon la revendication 9, **caractérisé en ce que** le détachement résulte d'une attaque chimique de la couche fragilisée.

15. Procédé selon la revendication 9, **caractérisé en ce que** le détachement résulte d'un traitement par ondes acoustiques de la couche fragilisée.

## Claims

1. Method for forming a semiconductor substrate that may be dismantled, comprising the following steps:
- introduction of gaseous species in the substrate (1) according to conditions allowing the constitution of an embrittled layer (4) by the presence in said layer of micro-cavities and/or micro-bubbles, a thin film of semiconductor material thus being delimited between the embrittled layer (4) and one face (2) of the substrate,
- thermal treatment of the substrate to increase the brittleness level of the embrittled layer (4), said thermal treatment being continued until the appearance of local deformations on said face (2) of the substrate (1) in the form of blisters but without generating exfoliations of the thin film during this step,
- epitaxy of semiconductor material (6) on said face of the substrate to provide at least one epitaxial layer on said thin film without generating exfoliations of the thin film during this step.

2. Method according to claim 1, **characterised in that** the introduction of gaseous species is carried out by ion implantation or plasma immersion implantation.

3. Method according to claim 2, **characterised in that** the introduction of gaseous species being carried out by plasma immersion implantation, the method is applied on two faces of the substrate.

4. Method according to claim 1, **characterised in that**, before the step of thermal treatment of the substrate, it provides for a step of forming a thickener, the thickness of which is sufficiently large so as not to generate exfoliations in the thin film and sufficiently small to avoid the separation of the substrate at the level of the embrittled layer during the step of thermal treatment of the substrate.

5. Method according to claim 4, **characterised in that** the thickener is totally or partially eliminated before the epitaxy step.

6. Method according to claim 1, **characterised in that** it provides for an additional step of subjecting the epitaxial layer to at least one step of forming components (7).

7. Method according to claim 6, **characterised in that** said step of forming components (7) is a step of forming photovoltaic components.

8. Method according to any of the previous claims, **characterised in that** it provides for an additional step of forming a protective layer on the epitaxial layer, said protective layer being intended to protect the epitaxial layer from a chemical attack intended for the separation of the substrate at the level of the embrittled layer.

9. Method for obtaining an element of semiconductor material, **characterised in that** it comprises the following steps:
- providing a semiconductor substrate that may be dismantled obtained by the method according to any of claims 1 to 8,
- dismantling of the semiconductor substrate that may be dismantled by detachment of this substrate at the level of the embrittled layer, the separation being either total to provide an element of semiconductor material forming a membrane and consisting of the thin film of semiconductor material and the epitaxial layer, or partial to provide one or several elements of semiconductor material forming one or several components and consisting of a part of the thin film of semiconductor material and the epitaxial layer.

10. Method according to claim 9, **characterised in that** it provides for an additional step of fastening of the epitaxial layer onto a support before the step of dismantling.

11. Method according to claim 9, **characterised in that** the detachment results from the application of a tensile stress and/or a shear stress.

12. Method according to claim 9, **characterised in that** the detachment results from the implementation of a step of introducing additional gaseous species into the embrittled layer, then a step of mechanical stress and/or thermal treatment of the embrittled layer.

13. Method according to claim 9, **characterised in that** the detachment results from the application of an opening stress at the level of the embrittled layer.

14. Method according to claim 9, **characterised in that** the detachment results from a chemical attack of the embrittled layer.

15. Method according to claim 9, **characterised in that** the detachment results from a treatment by sound waves of the embrittled layer.

## Patentansprüche

1. Verfahren zur Herstellung eines zerlegbaren Halbleiter-Substrats, umfassend die folgenden Schritte:
- Einbringen gasförmiger Spezies in das Substrat (1) unter Bedingungen, welche die Bildung einer geschwächten Schicht (4) durch die Anwesenheit von Mikro-Kavitäten oder/und von Mikro-Blasen in dieser Schicht ermöglichen, wobei auf diese Weise eine dünne Schicht aus Halbleiter-Material zwischen der geschwächten Schicht (4) und einer Oberfläche (2) des Substrats begrenzt ist,
- thermisches Behandeln des Substrats, um den Grad der Schwächung der geschwächten Schicht (4) zu erhöhen, wobei die thermische Behandlung bis zum Auftreten von lokalen Deformationen der Oberfläche (2) des Substrats (1) in Form von Blasen durchgeführt wird, aber ohne bei diesem Schritt Abblätterungen der dünnen Schicht zu erzeugen,
- Aufwachsen von Halbleitermaterial (6) auf die Oberfläche des Substrats, um wenigstens eine auf die dünne Schicht aufgewachsene Schicht zu erzeugen, ohne bei diesem Schritt Abblätterungen der dünnen Schicht zu erzeugen.

2. Verfahren nach Anspruch 1, **dadurch gekennzeichnet, dass** das Einbringen von gasförmigen Spezies durch Ionen-Implantation oder durch Plasma-Immersions-Implantation verwirklicht wird.

3. Verfahren nach Anspruch 2, **dadurch gekennzeichnet, dass** das Einbringen von gasförmigen Spezies durch Plasma-Immersions-Implantation verwirklicht wird, wobei das Verfahren auf beide Oberflächen des Substrats angewendet wird.

4. Verfahren nach Anspruch 1, **dadurch gekennzeichnet, dass**, vor dem Schritt der thermischen Behandlung des Substrats, ein Schritt einer Bildung eines Verdickers vorgesehen ist, dessen Dicke hinreichend groß ist, um keine Abblätterungen in der dünnen Schicht zu erzeugen, und hinreichend klein ist, um das Trennen des Substrats auf dem Niveau der geschwächten Schicht beim Schritt der thermischen Behandlung des Substrats zu verhindern.

5. Verfahren nach Anspruch 4, **dadurch gekennzeichnet, dass** der Verdicker vor dem Schritt des Aufwachsens vollständig oder teilweise eliminiert wird.

6. Verfahren nach Anspruch 1, **dadurch gekennzeichnet, dass** ein zusätzlicher Schritt vorgesehen ist, die aufgewachsene Schicht wenigstens einem Schritt der Herstellung von Bauelementen (7) zu unterziehen.

7. Verfahren nach Anspruch 6, **dadurch gekennzeichnet, dass** der Schritt der Herstellung von Bauelementen (7) ein Schritt der Herstellung von photovoltaischen Bauelementen ist.

8. Verfahren nach einem der vorhergehenden Ansprüche, **dadurch gekennzeichnet, dass** ein zusätzlicher Schritt vorgesehen ist, eine Schutzschicht auf der aufgewachsenen Schicht zu bilden, wobei die Schutzschicht dazu bestimmt ist, die aufgewachsene Schicht gegen einen chemischen Angriff zu schützen, der dazu bestimmt ist, das Substrat auf dem Niveau der geschwächten Schicht zu trennen.

9. Verfahren, um ein Halbleitermaterial-Element zu erhalten, **dadurch gekennzeichnet, dass** es die folgenden Schritte umfasst:
- Bereitstellen eines zerlegbaren Halbleiter-Substrats, welches durch das Verfahren nach einem der Ansprüche 1 bis 8 erhalten wird,
- Zerlegen des zerlegbaren Halbleiter-Substrats durch Ablösen von dem Substrat auf dem Niveau der geschwächten Schicht, wobei die Trennung entweder vollstandig ist, um ein Halbleitermaterial-Element zu liefern, welches eine Membran bildet und aus der dünnen Schicht aus Halbleitermaterial und der aufgewachsenen Schicht gebildet ist, oder teilweise ist, um ein Halbleitermaterial-Element oder mehrere Halbleitermaterial-Elemente zu erhalten, welches/welche ein oder mehrere Bauelemente bildet/bilden, und welches/welche aus einem Teil der dünnen Schicht aus Halbleitermaterial und der aufgewachsenen Schicht zusammengesetzt ist/sind.

10. Verfahren nach Anspruch 9, **dadurch gekennzeichnet, dass** ein zusätzlicher Schritt vorgesehen ist, die aufgewachsene Schicht vor dem Schritt des Zerlegens auf einem Träger zu fixieren.

11. Verfahren nach Anspruch 9, dadurch gekennzeichet, dass das Ablösen aus der Anwendung einer Zugbelastung oder/und einer Scherbelastung resultiert.

12. Verfahren nach Anspruch 9, **dadurch gekennzeichnet, dass** das Ablösen aus der Durchführung eines Schritts resultiert, zusätzliche gasförmigen Spezies in die geschwächte Schicht einzubringen, und dann eines Schritts der mechanischen Belastung oder/und der thermischen Behandlung der geschwächten Schicht.

13. Verfahren nach Anspruch 9, **dadurch gekennzeichnet dass** das Ablösen aus der Anwendung einer Offnungsbelastung auf dem Niveau der geschwächten Schicht resultiert.

14. Verfahren nach Anspruch 9, **dadurch gekennzeichnet, dass** das Ablösen aus einem chemischen Angriff auf die geschwächte Schicht resultiert.

15. Verfahren nach Anspruch 9, **dadurch gekennzeichnet, dass** das Ablösen aus einer Behandlung der geschwächten Schicht mit akustischen Wellen resultiert.
